Europäisches Patentamt

European Patent Office

Office européen des brevets

(19)

(11) Publication number: **0 308 294**
**A2**

(12) **EUROPEAN PATENT APPLICATION**

(21) Application number: **88402216.1**

(22) Date of filing: **02.09.88**

(51) Int. Cl.⁴: **G 06 F 13/14**

(30) Priority: **18.09.87 US 99168**

(43) Date of publication of application:
**22.03.89 Bulletin 89/12**

(84) Designated Contracting States: **DE FR GB IT**

(71) Applicant: **SGS-THOMSON MICROELECTRONICS, INC.**
**(a Delaware corp.)**
**1310 Electronics Drive**
**Carrollton, TX 75006  (US)**

(72) Inventor: **Powell, John N.**
**c/o Cabinet Ballot-Schmit 84 avenue Kléber**
**F-75116 Paris  (FR)**

(74) Representative: **Ballot, Paul Denis Jacques**
**Cabinet Ballot 84, avenue Kléber**
**F-75116 Paris  (FR)**

(54) **Noise-resistant arbiter circuit.**

(57) The invention relates to an arbiter circuit designed to respond to the first in time of two input signals.

RS latches are commonly formed by cross-coupled NAND gates made with transistors in connected input and output circuits. According to the invention, the transistors are sized and selected to have relative current capacities such that the value of their metastable output voltage is below the "trip point" of the next circuit in line so that the metastable voltage value is treated as a logical zero value, and thus does not propagate through the system.

FIG.2

# Description

## Noise-resistant arbiter circuit

The present invention relates generally to integrated logic circuits, and more particularly to an arbiter circuit designed to respond to the first in time of two inputs.

## BACKGROUND

The use of an RS latch formed by cross-coupled NAND gates is well known in the art. Series of such latches are commonly used in the logic circuits of a computer system. This configuration has the property that the first input to transfer from a quiet state (logic zéro or logic one, as preferred) to an active state will force the associated latch output into a corresponding state which differs from the quiet state of that output, and will also block a signal on a second input from propagating through the latch. Such a circuit has a positive feedback loop for faster switching time, as is well known in the art. Transistors are commonly used as the switches. Such a circuit has a finite resolving time, i.e. the minimum time period required between voltage rises on the two inputs for the output voltage to be predictable.

It is also well known that such circuits suffer from an inherent problem, namely that, if two inputs start to rise at the same time, or if there is a noise pulse on one or the other of the inputs, the circuit may switch state only partially. This condition is called a metastable state because it lasts for an indefinite time which is long, compared to the switching time of the circuit, but is short, compared to a conventional pulse width time. A circuit next in line or in series may respond to a metastable state by producing an unwanted signal which propagates through the system to produce unanticipated results. It is also possible for the output of the latch to oscillate, producing a train of pulses.

## THE INVENTION

Accordingly, it is an object of the invention to provide an improved arbiter circuit resistant to the consequences of metastable states.

Briefly, transistors in connected input and output circuits, such as the aforementioned latches, are sized and selected to have relative current capacities such that the value of their metastable output voltage is below the trip point of the next circuit in line, the "trip point" being the input voltage level which is sufficient to cause a circuit to change its output signal to a different state, so that the metastable voltage value is treated as a logical zero value, and thus does not propagate through the system.

## DRAWINGS

Figure 1 is a block diagram, captioned "METASTABLE SAFE ARBITER" of one embodiment of the arbiter circuit of the present invention ;

Figure 2 is a more detailed, yet still simplified, transistor-by-transistor diagram of the embodiment of Figure 1 ;

Figure 3 is a schematic diagram, captioned "QUEUING ARBITER" of the circuit of Figure 1, with input latches added ; and

Figure 4 is an enlarged and detailed diagram, entitled "MODIFIED D FLIP-FLOP", of the input latch shown in Figure 3.

## DETAILED DESCRIPTION

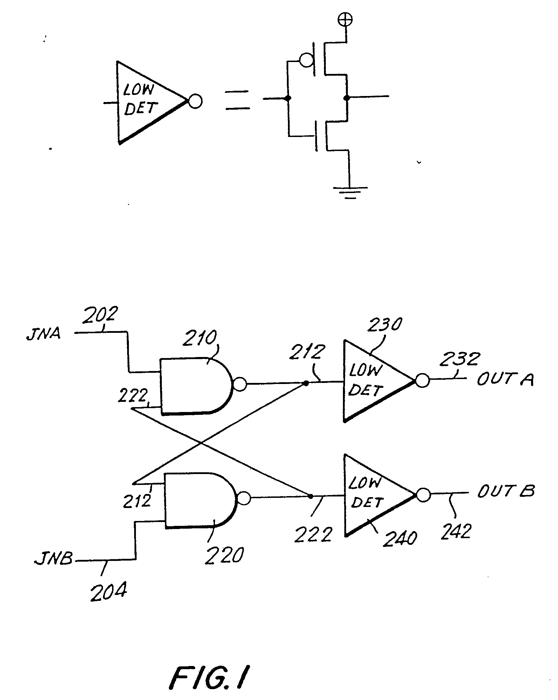

Figure 1 illustrates an arbiter circuit in which input A and input B are each connected through a NAND gate to an inverter, acting as a discriminator, and thence to corresponding respective output A and output B terminals. The two NAND gates 210 and 220 form a conventional RS latch.

It is well known that the RS latch has a quiescent state in which both inputs A and B are low and both output terminals 212 and 222 are high. It is also well known that there is a first stable voltage state in which input A is high, input B is low, output terminal 212 is high, and output terminal 222 is low. Thus, the final result is that output 212 being high, corresponds to the high input state at input A, and output 222, being low, corresponds to the low input state at input B. Similarly, if input B is high and input A is low, output terminal 222 will be high and output terminal 212 low.

It is also well known that, if the voltages on both input A and input B rise simultaneously, or within the resolving time of the circuit, the situation will be unstable, in that both NAND gates 210 and 220 are contending to establish dominance, i.e. which one's input will control the output signals. This "metastable" state will flip in a short but indeterminate period of time to one of the two stable voltage states or back to the quiescent state.

Using conventional NAND gates, the voltage value of the metastable output voltage of the RS latch is approximately halfway between the conventional power supply voltage of 5 volts and ground or O volt.

However, when two inverters 230 and 240, acting as discriminators, are connected respectively to outputs 212 and 222 of the conventional RS latch, the metastable voltage value will not be reliably either above or below the trip point of inverters 230 and 240, so that it is not possible to predict, in advance, what the output voltages of the inverters will be when there is a metastable state present.

According to the present invention, the current capacities of the transistors used with NAND gates 210 and 220 are modified so that there is a predictable metastable voltage value present on the output terminals, and this voltage value is set to be reliably on one side or the other of the trip point of the discriminator.

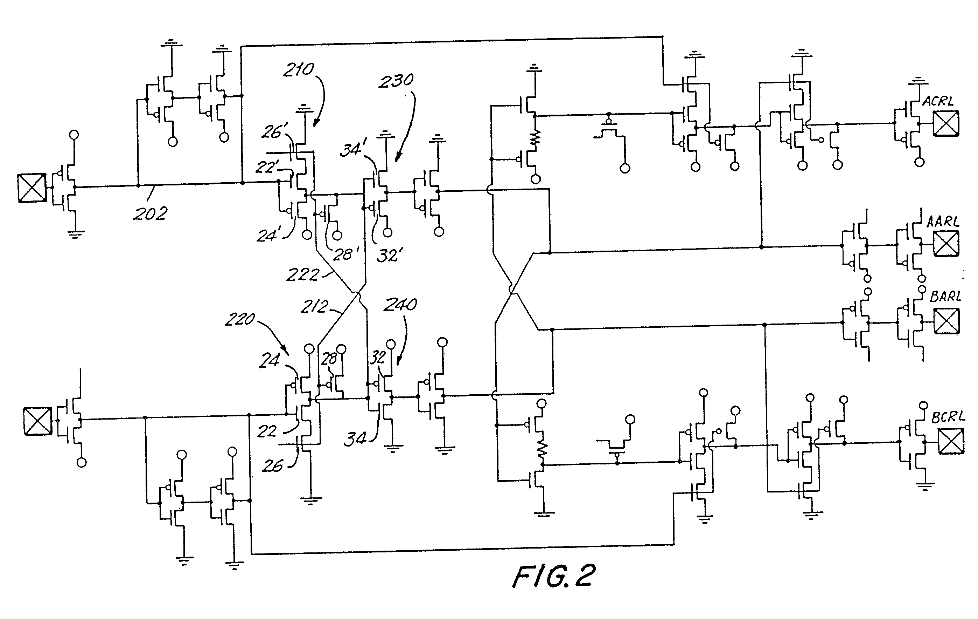

Figure 2 shows the circuit of Figure 1 in greater detail. NAND gate 220 is a conventional CMOS (Complementary Metal Oxide Semiconductor) circuit having N-channel transistors 22 and 26 connected in series between output node 222 and ground and conventional P-channel pull-up transistors 24 and 28 connected in parallel between node 222 and the power supply terminal. NAND gate 210 has the same construction, with corresponding transistors bearing the same reference numerals, only primed.

When a metastable voltage state is present, the voltage on output terminal 222 of gate 220 will be at some intermediate value between logic 1 (typically five volts) and logic zero (typically ground). That, in turn, will drive transistors 26' and 28' of gate 210 less hard than they are meant to be, i.e., the transistors will not be fully on or conductive and will not be fully off or blocked. Similarly, an intermediate voltage level on node 212 of gate 210 will result in transistors 26 and 28 being partially turned on.

Those skilled in the art will readily be able to select conventional transistor widths for the output transistors 26 and 28 and 26' and 28' to result in a desired metastable voltage of about 2.6 volts, about half the power supply voltage.

P-channel transistor 32 of inverter 230 and N-channel transistor 34 of inverter 240 were constructed to have a ratio of widths of 1/4, with the result that the trip point of inverter 240 was lowered from the usual value of approximately half the power supply voltage to a value of about 1/4 the power supply voltage.

Since the quiescent voltage levels of output nodes 212 and 22 are conventionally logic 1 or +5 volts, the presence of a metastable state will lower the voltage on terminals 212 and 222 to about half, to a value of 2.6 volts. Since the trip points of inverters 230 and 240 are set at about 1.3 volts, inverters 230 and 240 do not respond to the change in voltage from 5 to 2.6 volts due to the metastable state. The voltage values of output terminals 232 and 242 are, therefore, unaffected by the presence of a metastable state within the RS latch. If whatever disturbance set off the metastable was not sufficient to flip the latch into one or the other stable output states, but the latch returns to its quiescent state, then the output terminals exhibit no change. If the disturbance is sufficient to flip the latch into one or the other definite voltage state, then the input is treated as a "legal" input and the output terminals change to reflect that status.

Another undesirable situation is one in which a noise pulse has been coupled into the RS latch and has caused the output terminals to vary or oscillate from their normal value. For there to be trouble, it is not necessary that the metastable state be reached, only that the fluctuation in voltage be sufficient to trip other logic units within the circuit. The advantage of lowering the trip point of the inverters that are connected downstream of the RS latch to a point 3/4 of the way between the normal power supply voltage and ground is that the circuit is therefore rendered more resistant to fluctuations of the power supply potential about the normal 5 volt voltage level.

It is not necessary for the practice of the invention in its fullest form for the NAND gates to have a level of about half the power supply and for the inverters to be further away from the conventional trip point. The NAND gates could be configured so that the metastable voltage level is close to ground or close to the positive power supply level. In such a case, an inverter or other logic circuit next in series could have the conventional trip point of about half the power supply level.

Those skilled in the art will readily be able to apply the principles of the invention to other configurations such as active low and active high logic and circuits in which the power supply is negative with respect to ground.

The preceding discussion has assumed that the sole function of the circuit is to respond to the first in time of two inputs A and B, and that there is no concern about the response, if any, to the second input. Many system configurations do require that both inputs be responded to. In such a case, it is necessary to impose requirements on the input signals or to introduce circuitry that would correct for undesired input signal configurations. For example, if input B has a pulse length that is shorter than that of input A, and input A is first in time, then when the input A signal drops back to ground, input B would have disappeared and the system will respond only to input A. If input B is first in time, then output B will be asserted (propagate to the latch output) until the input B signal drops back to ground, after which the output A signal will be asserted.

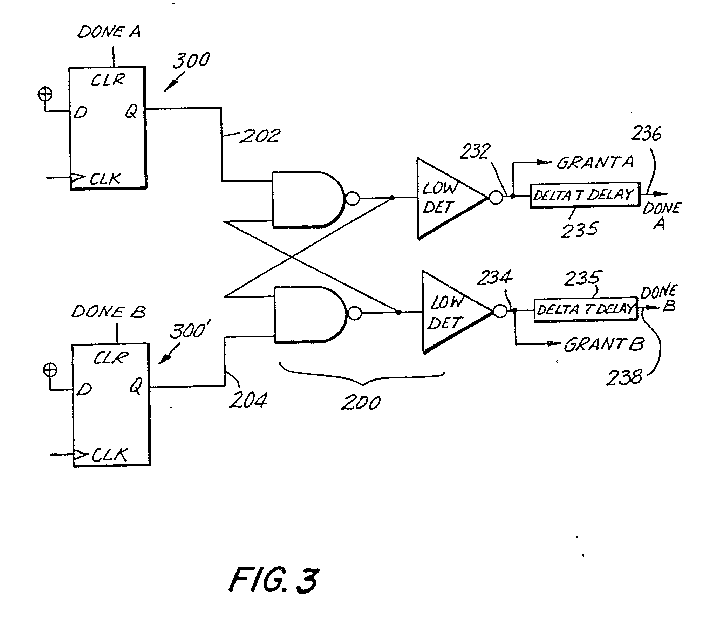

The problem of responding to both of two inputs in sequence can be solved by the addition of respective input latches 300 and 300' on the input A and input B data paths, as shown in Figure 3, captioned "QUEUING ARBITER".

Assume that the signal on input A has arrived first in time, followed shortly thereafter by the signal on input B. Both flip-flops 300 and 300' are latched with a +5 volt output. Since input A was first, arbiter circuit B has responded by imposing an output signal on nodes 232 and 234, in which node 232 is high and 234 is low. The high signal on node 232 travels along the wire labeled "GRAND A" to whatever subsequent circuits are involved in the system. The same signal is delayed through delay box 235 and arrives on terminal 236 after a fixed time T. That signal is fed back into the "DONE A" terminal on input latch flip-flop 300 to clear flip-flop 300 and force the output terminal 202 to the logic low state or ground. In that case, circuit 200 switches back to the opposite state, in which node 234 is high and node 232 is low. The second signal in time, that of input B, is then propagated into the remainder of the system and processed in whatever manner has been specified. The signal on node 234 arrives at node 238 and is connected to the "DONE B" terminal on flip-flop 300′ and then clears flip-flop 300′. At the end of this sequence, both flip-flops 300 and 300′ are ready to receive a new input and both input signals have been serviced by this system.

The delay line 235 could be replaced by an acknowledgement signal from the remainder of the system, indicated that the remainder is ready to accept the next input. In such a case, there would have to be a provision made for the acknowledgement signal to last for a minimum amount of time. One feature of this invention is that the delayed input latched signal also clears the latch, so that it is guaranteed that the clearing signal will last for a sufficient time to accomplish the function of clearing. The clearing function is therefore immune to noise. If flip-flop 300 or 300′ should flip into a metastable state at the start of the clearing signal, it does not matter because the clearing signal remains in force until terminal 202 settles at ground and that change is propagated through arbiter 200.

Figure 3 shows the arbiter circuit described above and indicated by the bracket labeled "200" preceded by two latch circuits 300 and 300′ which will be described below. The output stage of the queuing arbiter comprises a delay circuit which delays the output signals of Figure 1 (indicated on the lines 232 and 234) by a fixed delay, to generate signals on line 236 and 238 which are fed back to the input latches 300, 300′ to clear the latch and restore it to the default state.

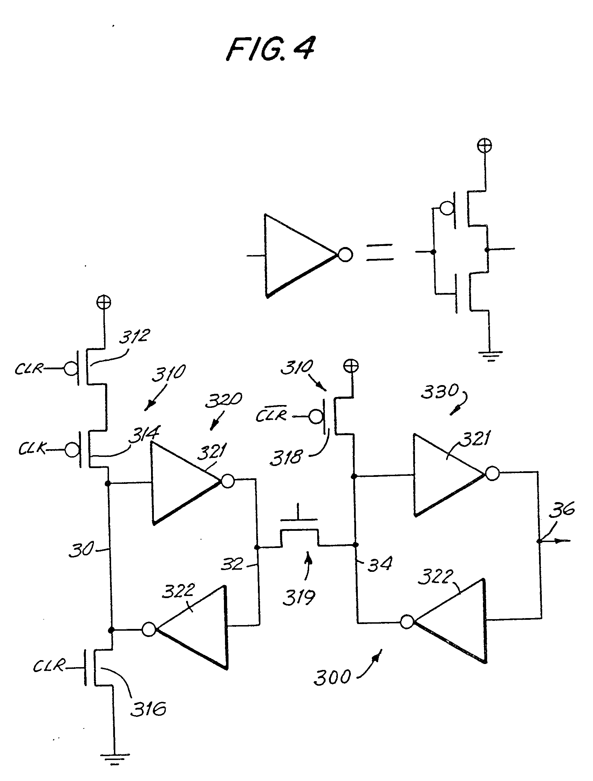

The details of circuit 300 are illustrated in Figure 4, showing that the circuit is a modified D flip-flop, in which the conventional input is tied permanently to +5 volts and the input signal comes in on the clock terminal. The flip-flop consists of two latches labelled 320 and 330 which are modified from a standard flip-flop latch, as will be described below.

In the quiescent state between signals, standard voltage values will be impressed on the two latches. CLEAR signals operating through a clear circuit, which is indicated by the arrows labelled 310 and comprises transistors 312 and 318, operate when the clear signal is initially high and switches to a low state to impress signals of +5 volts on nodes 30 and 34. Correspondingly, output node 36, referred to as the date storage node, is maintained at a ground state by cross-coupled inverters 321 and 322. When the input signal is asserted and the clock signal goes high, transistor 319 becomes conductive and node 32 is connected to node 34 so that inverters 321 and 322 contend to establish the voltage of 34. Since inverter 321 has a much higher current capacity than inverter 322, node 32 dominates and node 34 is forced to a low value. Node 36 is thus forced to the high value. Latch 330 maintains node 26 at the high value until the circuit is cleared. This happens, as will be described below when the "done" signal arrives on the clear terminal and the input signal on the clock terminal is removed. For purposes of reference, the state in which node 34 is at +5 volts and node 36 is at ground will be referred to as the "default voltage" state. Latch 330 will be switched in response to an input signal on the clock terminal so that reference latch 320, which stores a reference signal, can flip the state of latch 330 to the data state.

The noise resistance of the input latch is provided by careful sizing of the transistors in the cross-coupled inverters. The cross-coupled inverters form a positive feedback loop having two stable states and a metastable state. This as is well known in the art, is characteristic of latches of this type. The stable states are those, of course, in which one input is logic low or zero and one is logic high or one. Conventionally, logic low is ground and logic high is +5 volts, although those skilled in the art will readily be able to apply the principles of the invention to systems in which logic one is a low voltage or in which the power supply voltage is negative with respect to ground. The metastable voltage values on nodes 30, 32, 34 and 36 are indicated in the circles in Figure 4, being respectively 2.3 volts, 3.2 volts, 2.4 volts and 1.5 volt. The circle at the right of Figure 4 indicates the trip point voltage of the next logic circuit in sequence. This is, in the case of Figure 3, the input to the NAND gates.

For purposes of illustration, consider the operation of the flip-flop of Figure 4. Assume that the clear line has been asserted for a long time, so that nodes 30 and 36 are a hard low (ground). Nodes 32 and 34 will be high (+5 volts). At this time, the clear line is deasserted and falls back to ground. Whether the clock signal is high or not does not matter because there is no change in the circuit. Therefore, it does not matter if the input signal happens to last for a longer period of time than the cycle time through the circuit of Figure 3. Assume now that a noise pulse appears on the clock line, dropping it from +5 volts to some lower voltage which is not enough to make the feedback path of latch 320 flip state, but is enough to force it into a metastable balance state. Node 32 will then be balanced at 3.2 volts and node 30 will be balanced at 2.3 volts. This value of 3.2 volts will be propagated through to node 34 through transistor 319 which is assumed still to be on, since the transient noise pulse was not enough to shut it off. Node 34 will then be forced to 3.2 volts, but this voltage is not high enough to exceed the trip point of inverter 321, because inverter 321 has been constructed to have its trip point above 3.2 volts. If latch 320 resumes its reference state, then nothing has happened to latch 330. If latch 320 does flip to the opposite state, then the noise pulse was sufficient in magnitude to cause a transition, and is assumed to be a legitimate input pulse. This criterion of pulse magnitude amounts to a criterion on both the voltage and the duration of the input pulse. Pulses that are too short or too low in voltage will not flip latch 320. If the flip does occur, then node 32 will flip to the +5 volts state and latch 330 will flip in accordance with it. This is just the proper operation for a legitimate input pulse.

The system thus described as a queuing arbiter in Figure 3 has the property that it receives and stores both input signals arriving closely in time and is also resistant to fluctuations in the input lines that may flip one or the other of the positive feedback loops in the latches, or in the arbiter circuit into a metastable state. As was described above, many applications will require only the noise-resistant arbiter unit 200 and will not require the queuing feature, as provided by the input section.

The other type of noise pulse which should be considered is one in which a positive pulse appears when the clock signal is low. In this case, the system is assumed to be in the default state, with clear and clock both low. A positive pulse appears on the clock line and creates a conductive path through transistor 319 between node 32, which is at ground in the default state, and node 34, which is high. This pulse, propagating into latch 330, may force it into the metastable state. If latch 330 falls back from the metastable state into the default state, there is no effect, because the metastable state voltage on node 36 of 1.3 volt is below the trip point voltage of the next circuit in line, so that the next circuit ignores the metastable state. If latch 330 does flip states, then it is assumed that the input pulse was a legitimate input pulse.

The essential point in fabricating a latch with this appropriate noise resistance to both negative-going and positive-going pulses is the careful sizing of the current capacities of the inverters in the latches. The result of the sizing is that the metastable voltage state on node 32 is less than the trip point of the subsequent latch 330 and the metastable state on the output terminal 36 is less than the trip point of the next circuit in line. This condition may be rephrased by stating that the trip points and the metastable voltage values are set such that the next circuit in line treats a metastable state as being the default state. Metastable states are thus ignored if they fall back to the default state or are assumed to be legitimate if they last long enough to force the latch into the data state.

Those skilled in the art will understand how to balance the current capacities of CMOS inverters such as this to achieve a metastable balance point and to achieve a threshold trip point within a broad range. The exact transistor width of the various transistors involved will depend on the transconductance of the transistors, of course, and that, in turn, depends on a number of process parameters. For one conventional CMOS process, the transistors within the inverters were sized according to the numerals indicated in Figure 4. In this notation, the upper numeral refers to the width of the P-channel transistor in the inverter and the lower numeral refers to the width of the N-channel transistor. For example, in inverter 321, 200 microns is the width of the P-channel transistor and 100 microns is the width of the N-channel transistor.

When there are two lower numerals, they indicate the width and length of the lower or upper transistor, as the case may be. Within a reasonable approximation, the current capacity of the transistor is proportional to its width, for the same degree of turn-on, and these numerals will serve as a guide to sizing transistors. Those skilled in the art will readily be able to adapt this information to their own circuit designs.

**Claims**

1 - A noise-resistant latch circuit for storing input data on a data storage terminal (202) comprising :
- an input circuit means (300) responsive to an input signal for switching said data storage terminal from a stable default voltage state to a stable data voltage state ; and
- means for clearing said data storage terminal from said stable data storage voltage state to said default voltage state characterized in that :
- said data storage terminal (202) is located in a current path from a power supply voltage to ground and between
at least one upper circuit element connected between said power supply voltage and said data storage terminal and
at least one lower circuit element connected between said data storage terminal and ground, both of said at least one upper and lower circuit elements being connected to and controlled by said input circuit means (300) to assume one of said stable default or data storage voltage states in response to a stable input signal and also to assume a metastable voltage state, all of said at least one upper and lower circuit elements having predetermined upper and lower impedance values such that each of said metastable voltage states has a predetermined voltage value that is closer to said default state than to said date storage state.

2 - Circuit according to claim 1, wherein
- a following logic circuit is provided, connected to said data storage terminal, and having :
a first internal state responsive to said default voltage state,
a second internal voltage state responsive to said data voltage state, and
a trip point voltage, intermediate said default voltage and said data voltage, and closer to said data voltage than is said metastable voltage, whereby said following logic circuit responds to said metastable voltage state and to said default voltage state in the same manner.

3 - A circuit according to claim 1, in which said data storage terminal (202) is a node in a second latch circuit (200) , said input circuit means (300) comprises clearing means for forcing said second latch circuit (200) into said default voltage state ; and
said circuit further comprises an input forcing latch for storing a reference voltage state and said input circuit means opens a conductive path between said forcing latch and said second latch (200) whereby said forcing latch forces said second latch (200) into said stable voltage state.

FIG. 1

FIG.2

FIG. 3

# FIG.4